# EUROPEAN PATENT SPECIFICATION

(11) **EP 3 172 850 B1**
(45) Date of publication and mention of the grant of the patent: **30.12.2020**
(21) Application number: 15827271.6
(22) Date of filing: 23.07.2015
(51) Int. Cl.: H04B 10/2575, H04B 10/291, G02F 1/015, G02B 6/42, H01L 31/0352, H04B 10/40

(54) **MULTILAYER VERTICAL CAVITY SURFACE EMITTING ELECTRO-ABSORPTION OPTICAL TRANSCEIVER**
MEHRSCHICHTIGER OBERFLÄCHENEMITTIERENDER OPTISCHER ELEKTROABSORPTIONSSENDER-EMPFÄNGER MIT VERTIKALEM HOHLRAUM
ÉMETTEUR-RÉCEPTEUR OPTIQUE MULTICOUCHE ÉLECTROABSORBANT À CAVITÉ VERTICALE ET À ÉMISSION PAR LA SURFACE

(30) Priority: 27.07.2014 US 201462029499 P
(43) Date of publication of application: 31.05.2017
(73) Proprietor: Mer-Cello Wireless Solutions Ltd., 4934827 Petach-Tikva (IL)
(72) Inventor: BEN EZRA, Yossef, 7657310 Rehovot (IL); BEN HAIM, Yaniv, 7685400 Kfar-Mordechai (IL)
(74) Representative: Richter, Allen
(86) International application number: PCT/IB2015/055600
(87) International publication number: WO 2016/016783

(56) References cited:
- WO-A1-98/31080
- WO-A1-2005/012971
- GB-A- 2 378 069
- US-A- 5 757 837
- US-A1- 2003 223 756
- US-A1- 2014 036 937
- US-B2- 8 666 253

## Description

### CROSS REFERENCE TO RELATED APPLICATIONS

This application is related to and claims priority from US Provisional Patent Application No. 62/029,499 filed July 27, 2014 titled "A method and device for full duplex optical transmission of analog and digital signals based on Multilayer Vertical Cavity Surface Emitting Electro-Absorption Transceiver (ML-VCSE-EAT)".

### FIELD

Embodiments methods disclosed herein relate in general to integrated optoelectronic devices and systems and methods employing such devices.

### BACKGROUND

GB2378069 (D1) discloses an optical transceiver having an integrated structure that comprises a substrate 1, a VCSEL 2 on the substrate 1 to transmit an optical signal of a first wavelength in a first direction along an optical path, and a reception photodiode 6 integrated with the VCSEL 2 on the substrate 1 to detect an optical signal of a second wavelength, which is different to the first wavelength, travelling along the optical path in a second direction opposite to the first direction. The VCSEL 2 and the reception photodiode 6 are positioned in sequence along the optical path and one of the devices, for example the photodiode 6, is adapted to allow one of the optical signals to pass through it in its passage along the optical path. The fact that the two devices are integrated in this manner, either by being grown on a common substrate or by flip-chip bonding, means that such an optical transceiver is capable of bidirectional optical communication over a single optical fibre without requiring the use of additional optical components to increase coupling efficiency to the optical fibre. This renders further components on the substrate unnecessary, and enables the transceiver to be produced at very low cost. (Abstract)

US2003223756 (D2) discloses an optical transceiver for detecting an incoming light beam and for transmitting an outgoing light beam along a common optical axis. Such an optical transceiver provides a compact optical transceiver that is suitable for a wide variety of applications. (Abstract).

WO9831080 (D3) discloses an optoelectronic module that includes one or more VCSEL transmitters and/or photodetectors coincidentally aligned along a common central longitudinal axis. Differing wavelengths of light can be received and transmitted bv the optoelectronic module optically coupled to a single optical fiber or in a free-space link. The optoelectronic module is able to receive two wavelengths and transmit one wavelength, or can transmit two wavelengths in the optical link. The VCSEL transmitter can be optically pumped by a vertically integrated pump VCSEL. A parallel optical link supports transmission and reception for each duplex channel on a single optical fiber. The parallel optical link includes an array of optical fibers, a first array of optoelectronic modules optically coupled to the array of optical fibers to transmit a laser signal having a first wavelength and receive a laser signal having a second wavelength, and a second array of optoelectronic modules optically coupled to the array of optical fibers to transmit the laser signal having the second wavelength and receive the laser signal having the first wavelength. A multichannel data distribution system enables bidirectional distribution of data between a central distribution point and a number of nodes optically linked to the central distribution point. (Abstract)

US2014036937 (D4) discloses OTDM coherent transceiver and related methods and apparatus that employ a pulsed source which advantageously allows higher symbol rates without requiring higher speed electronics.

The application of radio-over-fiber (RoF) systems and methods in, for example, broadband wireless access networks has attracted much attention because it facilitates, inter alia, the transmission of data using a variety of protocols over a single fiber. Accordingly, RoF allows for the delivery of data to remote access units (RAUs) serving a variety of protocols. Such remote access units may include, for instance, cellular base stations and Wi-Fi Access Points for providing end-users access to multimedia content delivered via the Internet.

With the employment of the RoF technique, many of the required radio frequency (RF) signal processing functions can be performed at a centralized location prior to being distributed to the RAUs via the optical fibers. This provides important cost savings, allowing the RAUs to be simplified significantly, as they may only need to perform relatively basic optoelectronic conversion, filtering, and/or amplification functions.

Considering the ever-increasing capacity in data transmission by RF and optical carrier signals, efficient interfacing between the RF signals and optical signals at the centralized location is crucial.

Accordingly, the penetration of optical fibers for successfully implementing ROF-based or other broadband networks may largely depend on the performance and the costs of optical transceivers acting as the optical-radio interface. Cost-effective optical transceivers are thus expected to accelerate the introduction of wireless broadband services for making them more readily available in public venues.

The description above is presented as a general overview of related art in this field and should not be construed as an admission that any of the information it contains constitutes prior art against the present patent application.

### SUMMARY

Examples of embodiments relate, inter alia, to a device, system and method for full-duplex transmission of data encoded by signals using analog and/or digital representation techniques.
Example 1 includes an optical transceiver device (also referred to hereinafter as "OTD"), comprising a detection region for detecting light at a first wavelength for down-conversion and a modulation region for modulating light at a second wavelength longer than the first wavelength, wherein the detection region is substantially transparent to light at the second wavelength and located upstream to the modulation region with respect to direction of propagation of first wavelength light incident onto the detection region.
Example 2 includes the subject matter of example 1 and, optionally, wherein the detector region comprises a plurality of quantum wells.
Example 3 includes the subject matter of example 2 and, optionally, wherein the plurality of quantum wells ranges from 3 to 10 quantums wells
Example 4 includes the subject matter of any of examples 1-3 and, optionally, further comprises a reflecting layer for reflecting the second wavelength light for up-conversion.
Example 5 includes the subject matter of example 4 and, optionally, wherein the reflecting layer comprises a Distributed Bragg Reflective (DBR) mirror having a plurality of periodic variations of a characteristic parameter.
Example 6 includes the subject matter of example 5 and, optionally, wherein the number of periodic variations (e.g., grating periods) ranges from 20 to 50.
Example 7 includes the subject matter of example 4 and, optionally, wherein the reflecting layer is partially transparent and overlays a waveguide layer so that a portion of incident second wavelength light is reflected and another portion of the incident second wavelength light is coupled into the waveguide layer.
Example 8 includes the subject matter of example 7 and, optionally, wherein the reflecting layer comprises a semiconductor saturable absorber mirror.
Example 9 includes the subject matter of examples 1-8 and, optionally, further comprises a plurality of readout contacts for reading out a voltage fluctuation and/or an electric current generated due to first wavelength light incident onto the detection region.
Example 10 includes an array comprising a plurality of optical transceiver devices according to any of the examples 1-9.
Example 11 includes the subject matter of example 10 and, optionally, wherein each optical transceiver device is optically coupled an optical fiber for allowing full-duplex data transmission over each fiber.
Example 12 includes a communication system, comprising an optical transceiver device according any of the examples 1-11; and a wavelength division demultiplexer for separating first wavelength light from second wavelength light, wherein the optical transceiver device and the demultiplexer are formed integrally with each other.
Example 13 includes the subject matter of example 12 and, optionally, further comprises a splitter for splitting the second wavelength light into a plurality of second wavelength light portions, wherein the splitter is formed integrally with the transceiver device and the demultiplexer.
Example 14 includes the subject matter of example 13 and, optionally, further comprises an optical circulator, which is formed integrally with the optical transceiver device to allow full-duplex transmission of data carried by the modulated first wavelength light and the modulated and reflected second wavelength light.
Example 15 includes a method for enabling full-duplex data transmission comprising: launching modulated light at a first short wavelength from an optical fiber into a detection region of an optical transceiver device according to any of the examples 1-9 for reading out data carried by the modulated short wavelength light; launching unmodulated light at a second wavelength longer than the first wavelength from the optical fiber into the modulation region of the optical transceiver device; modulating at least a part of the second, longer wavelength light to obtain modulated, second long wavelength light; and reflecting the long wavelength modulated light into the optical fiber.

This summary is provided to introduce a selection of concepts in a simplified form, concepts that are further described below in the detailed description. This summary is not intended to identify key features or essential features of the claimed subject matter, nor is it intended to be used to limit the scope of the claimed subject matter.

### BRIEF DESCRIPTION OF THE DRAWINGS

Embodiments disclosed herein are described, by way of example only, with reference to the following accompanying drawings, wherein:
**FIG. 1** is a schematic illustration of an optical transceiver device of a communication system, according to an embodiment;
**FIG. 2** is a schematic illustration of an optical transceiver device of a communication system, according to another embodiment;
**FIG. 3** is a schematic illustration of an optical transceiver device integrated with optical components of a communication system, according to an embodiment;
**FIG. 4** is a schematic illustration of an array of optical transceiver devices that are operatively coupled with a respective plurality of optical fibers of a communication system, according to an embodiment;
**FIG. 5** is a schematic detailed block diagram illustration of a full-duplex communication system, according to an embodiment;
**FIG. 6** is a schematic illustration of an optical transceiver device of a communication system, according to a yet alternative embodiment; and
**FIG. 7** is flowchart illustration of method for performing full-duplex data transmission, according to an embodiment.

### DETAILED DESCRIPTION

Aspects of embodiments relate to a device, system and method for performing RF-to-optical conversion, also known as "up-conversion", and optical-to-RF conversion, also known as "down-conversion", and/or the full-duplex transmission of data encoded by signals using analog and/or digital representation techniques. According to an embodiment, an optical transceiver device (OTD) may provide an interface (for example an optical/RF interface) between a broadband fiber unit transmitting data to remote access units and a RF antenna unit located in a centralized location.

As already indicated, the transceiver functionality of the OTD may be full-duplex. Exemplarily, the OTD may act simultaneously as a detector of modulated optical signals and as a transmitter of modulated optical signals.

According to an exemplary embodiment, the optical transceiver device may comprise hybrid or monolithically integrated optical transceiver structures allowing full-duplex access to an optical network. The OTD may comprise a modulator based on electro-absorption (EA). In short, the optical transceiver device may comprise or embody an electro-absorption modulator (EAM). Accordingly, at some instances, the optical transceiver may be referred to as an EAM device. The OTD comprising or embodying the EAM may be suitable for simultaneous up-conversion and down-conversion of data carried by the optical signal according to analog and/or digital signal representation techniques. The EAM may be employed for up-conversion, i.e., for converting RF or wireless signals into the optical domain by e.g. external modulation of optical signals by a laser source. The EAM may also generate, optionally inherently, a photocurrent. This effect may be exploited to obtain converter properties for down-conversion of optical signals into RF signals. Therefore, an optical transceiver device disclosed herein can simultaneously be used as a modulator in up-conversion operation and as a photodetector in down-conversion operation.

Generally, a first, "short" wavelength for down-conversion may be used for detection (also referred to as "downlink detection"), and a second, "long" wavelength may be employed for modulation in up-conversion (also referred to as "uplink modulation"). The first wavelength is shorter than the second wavelength.

It should be noted that the terms "short" and "long" used herein in conjunction with wavelengths are to distinguish between light at different wavelengths and are, as such, relative terms. Consequently, short wavelength light has a wavelength that is shorter than long wavelength light. Correspondingly, long wavelength light has a wavelength that is longer than short wavelength light.

It is noted that the term "wavelength" as used herein may also encompass "range of wavelengths". Accordingly, a first range of shorter wavelengths of light may be employed for downlink detection and a second range of longer (than the first) wavelengths of light may be employed for uplink modulation.

It should further be noted that the term "light" may encompass wavelengths that are in the visible range as well as wavelengths that are not visible to the human eye including, for example, light or electromagnetic radiation in the infrared (IR) range.

To achieve downlink detection, light based on a first wavelength and incident onto the EAM may generate a voltage oscillation and/or a change in electrical current, which may then be further processed, e.g., to generate wireless signals.

Uplink modulation may be obtained by transmitting an unmodulated or continuous wave (CW) light from a central unit to a remotely located EAM, e.g., to an EAM in a remote access unit. It is noted that the terms "unmodulated" and "continuous wave" can be used interchangeably.

At the EAM, changes are imposed or invoked to the forbidden gap of the EAM. The wavelength of the unmodulated (CW) light is selected so that changes in the forbidden gap of the EAM causes corresponding changes in the amplitude of the incident light, resulting in modulated light. Modulated light is transmitted back from the EAM to the central unit. The transmission path of modulated light from the EAM may be referred to as "uplink".

According to an exemplary embodiment, the OTD comprising or embodying the EAM may have a multilayer structure that has different active regions for achieving sufficient high responsivity in downlink detection and sufficient modulation efficiency for uplink data transmission. More specifically, a first layer of the multilayer structure may be employed for downlink detection purposes and is designed to be responsive at a first, shorter, wavelength; and a second layer of the multilayer structure may be employed for uplink modulation purposes to be imposed on light with a second, comparably longer wavelength. The first layer may be above the second layer with respect to the propagation direction of short wavelength light, and may further be largely, substantially or completely transparent to light of the second, longer wavelength. Light at the second wavelength may be modulated and reflected back to the central unit. The modulation of the second wavelength may be invoked externally. Reflection of modulated light of the second wavelength back to the central unit may be effected exemplarily by a Bragg mirror.

Incoming first wavelength light may comprise analog and/or digital modulated components. Further, modulation of incoming second continuous or unmodulated long wavelength light may include the application of analog and/or digital data representation or modulation techniques.

The EAM functionalities of the OTD may for example be obtained by employing a Multilayer Vertical Cavity Surface Emitting Electro-Absorption Structure (M-SEAS), as outlined herein below in more detail.

While in some exemplary embodiments the OTD may be standalone, while in some other exemplary embodiments it may be integrally formed with additional components. The OTD may exemplarily be formed integrally with integrated circuits that are based on, e.g., CMOS manufacturing technology. In some embodiments, the OTD may exemplarily be formed integrally with a Radio Frequency Integrated Circuit (RFIC). In some embodiments, the OTD may be formed integrally and/or integrated in conjunction with, e.g., electrical components and/or with optical components that are, optionally, passive components. In some embodiments, the OTD may be formed integrally with an optical and/or electrical amplifier on the same substrate, to exemplarily amplify the local RF signal received by local antennas, e.g., at the received frequencies and power levels.

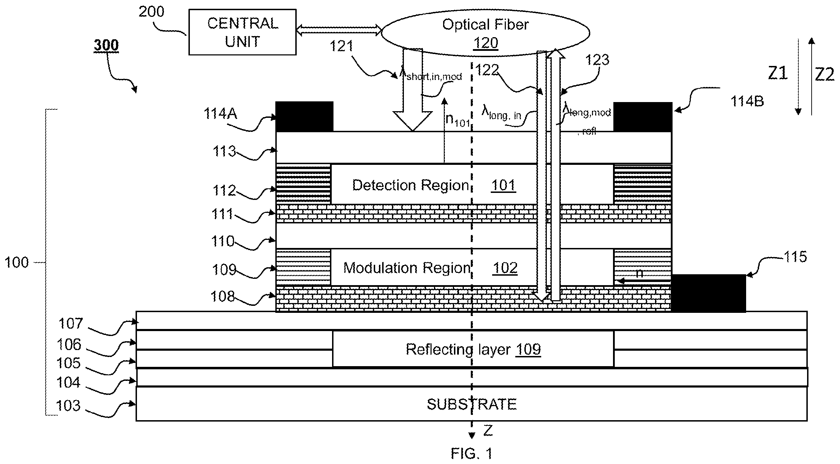

Reference is now made to **FIG.** 1. According an embodiment, an OTD **100** may, in combination with a central unit **200,** form a communication system **300** such as, e.g., a Radio-over-Fiber (RoF) communication system. Although some of the discussion herein refers to the employment of OTD **100** in RoF communication systems, this should be no means to be construed as limiting. Accordingly, OTD **100** may for example be employable as a component of digital communication systems.

OTD **100** may be considered to have a central axis **Z** and may comprise a detection region **101** and a modulation region **102.** Propagation of light in a positive **Z** direction **(Z1)** may herein be referred to as propagation in the downstream direction. Correspondingly, propagation of light in a negative **Z** direction **(Z2)** may herein be referred to as propagation in the upstream direction **Z.** Modulation region **102** is positioned downstream in the propagation direction **Z** of incident first, short wavelength light **121** and second unmodulated long wavelength light **122,** relative to detection region **101.** Correspondingly, detection region **101** is located upstream of modulation region **102.**

Modulation region **102** is located between a substrate **103** and detection region **101.** Detection region **101** is responsive to light **121** launched into OTD **100** from an optical fiber **120** at a first, short, wavelength **(λₛₕₒᵣₜ)** concerning its detection; and modulation region **102** is designed such as to be able to impose modulation onto light **122,** carried exemplarily by optical fiber **120,** at a second, long, wavelength **λ_{long},** which is longer than **λₛₕₒᵣₜ.** While detection region **101** is substantially transparent and, correspondingly, non-responsive to the second wavelength, the same detection region **101** allows detection of incident light **121** at the first, short, wavelength **λ_{short,in}.** Light **121** responsively engaging with detection region **101** at the first wavelength **λ_{short,in}** may herein be referred to as modulated first wavelength light **121** at **λ_{short,in},_{mod}** and light **122** at the second wavelength **λ_{long,in}** which engages with modulation region **102** for being modulated (e.g., externally) may herein be referred to as second wavelength light **122** at **λ_{long,in}.** Modulated light **123** at the second wavelength **(λ_{long})** emanating from OTD **100** in the upstream direction may herein be referred to as modulated second wavelength light **123 (λ_{long}, _{refl,mod}).**

In some embodiments, detection region **101** and modulation region **102** may be designed so that a minimum difference or wavelength separation between modulated first wavelength light **121(λₛₕₒᵣₜ,_{in,mod})** and second wavelength light **122** at **λ_{long,in}** may exemplarily range from 150 nm to 250 nm.

Generally speaking, OTD **100** may comprise any suitable material or combination of materials. OTD **100** may for example be based on GaAs or InP, in which case the short wavelength may be about 1300 nm and the longer wavelength may be about 1550 nm. Alternatively, the device may be also based on Si/SiO₂, in which case the wavelengths may range from about 890 nm to about 1100 nm.

The doping concentration of a layer or layers (e.g., detection region **101** and/or modulation region **102**) of OTD **100** may, for example, range from about 10¹⁶ to about 10¹⁸ cm⁻³.

With respect to the normal of the surface of detection region **101,** second wavelength light **123 (λ_{long}, _{refl,mod})** emanating from OTD **100** may be "vertically" emitting. Otherwise stated, the direction of propagation of second wavelength light **123 (λ_{long, refl,mod})** may be parallel to the normal n₁₀₁ of the upper surface of the layer embodying the detection region **101.**

According to an embodiment, detection region **101** may be embodied as a multiple quantum well (MQW) layer comprising, for example, from 3 to 10 quantum wells (QWs). The number of quantum wells may be selected based on the modulation and/or detection efficiency and/or the bandwidth of OTD **100.** The detection region may for example be based on InGaAsP or on any other suitable material or combination of materials.

According to an embodiment, modulation region or layer **102** may be optimized to achieve efficient modulation of the second wavelength **λ2** to obtain modulated, reflected second wavelength light **123 (A_{long,refl,mod}).** Modulation region **102** may for example be based on AlₓGa₁₋ₓAs,InₓGa₁₋ₓAs, InP, Si/SiO₂; or any other suitable material or combination of materials. In an embodiment, modulation may be imposed on long second wavelength light **123** after being reflected from modulation region **102** by a reflecting layer **109** included in OTD **100.**

Layer **109** for reflecting long wavelength light **123** may be implemented exemplarily by a Bragg or distributed Bragg reflector (DBR). The number of periodic variations of a characteristic in the DBR (e.g., the number of repeating grating periods) may for example range from 20 to 50. Modulated, reflected second wavelength light **123 (λ_{long,refl,mod})** may emanate from OTD **100** for coupling the modulated and reflected long wavelength light into optical fiber **120.**

In an embodiment, layers **104-107** surrounding reflecting layer **109** may be based on same materials as the reflecting layer yet doped, e.g., with Si or Carbon. Analogously, layers **108-110** surrounding the modulation region **102** and layers **111-113** surrounding the detection region **101** may respectively comprise materials of the modulation and detection region, yet may again be doped, e.g., with Si or Carbon. In an embodiment, layers **104-107** may be wider, i.e., have a larger lateral extension than layers **108-113.** Accordingly, a part of the upper surface of layer **107** may not be covered by layer **108.**

According to an embodiment, OTD **100** may include a plurality of conductive (e.g., metallic) contacts that may serve as input and/or output ports for analogue and/or digital signals. Input signals may be for example be employed for electrically driving modulation region **102.** For instance, conductive (e.g., metallic) a first or second contact **114A** and **114B** may be employed with a third contact **115** for reading out voltage or current oscillations that may be generated in detection region **101.** Further, first or second contacts **114A** and **114B** may be employed with third contact **115** for modulating long wavelength light **123.**

First and second contacts **114A** and **114B** may for example overlay layer **113,** which itself overlays detection region **101.** First and second contacts **114A** and **114B** may be positioned at some lateral distance from one another on layer **113,** for example, in juxtaposition with each other at distal edges of layer **113.** Third contact **115** may for example overlay a portion of layer **107** which is not covered by layer **108.** Further, third contact **115** may be laterally juxtaposed relative to modulation region **102** such as to be operably coupled therewith. For example, a vertical surface of third contact **115** having a surface direction indicated by normal (n) **(****FIG.** 1) pointing perpendicular relative to direction **Z,** may at least engage or make contact with a vertical surface of layer **109** facing the said vertical surface of third contact **115.**

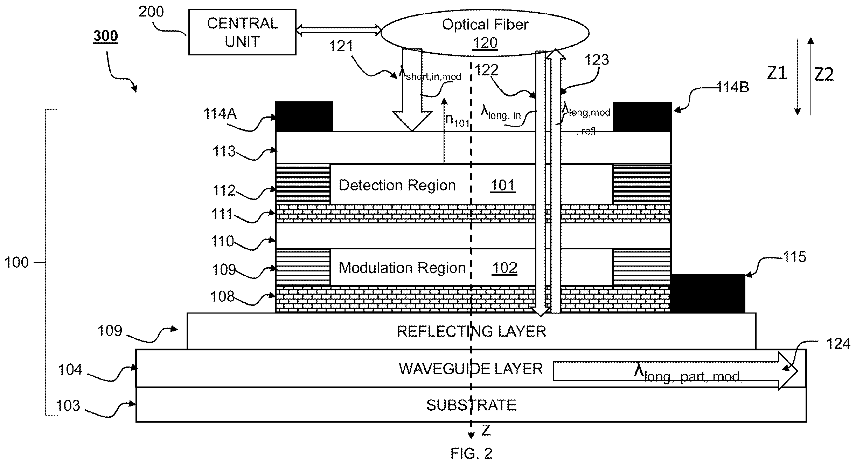

Third contact **115** may be employed in cooperation with first contact **114A** or second contact **114B** to enable modulation of, e.g., long wavelength light **123** reflected from reflecting layer **109.** More specifically, in an embodiment, third contact **115** may be coupled with modulation region **102** such to enable with, e.g., first contact **114A** or second **114B,** modulation of reflected second long wavelength light **(**λ**_{long,refl})** to obtain modulated second wavelength light **123 (**λ**_{long},_{refl,mod}),** e.g., by applying a modulating voltage between third contact **115** and first contact **114A** or second contact **114B** that changes the characteristics of modulation region **102** to impose modulation. Further reference is made to **FIG. 2****.** According to another embodiment, OTD **100** may be configured to allow adapting the transparency of reflecting layer **109** to the second, long wavelength light **122.** For example, reflecting layer **109** may be embodied by a semiconductor saturable absorber mirror (SESAM), which overlays a waveguide layer **104.** SESAM layer **109** may be located between modulation region **102** and waveguide layer **104.** Further, waveguide layer **104** may be sandwiched between substrate **103** and SESAM layer **109.**

The transparency of SESAM layer **109** may be adaptable from central unit **200,** e.g., through variation of laser power of the source for second, long wavelength light. In a scenario where the SESAM layer **109** is not fully reflective (i.e., it is partially transmissive), some portion of the incident wavelength light **122 (λ_{long,in})** may be coupled into waveguide layer **104** for routing a rest or residual portion of the second, longer wavelength light **124 (**λ**_{long,part})** to a destination different than fiber **120** for example.

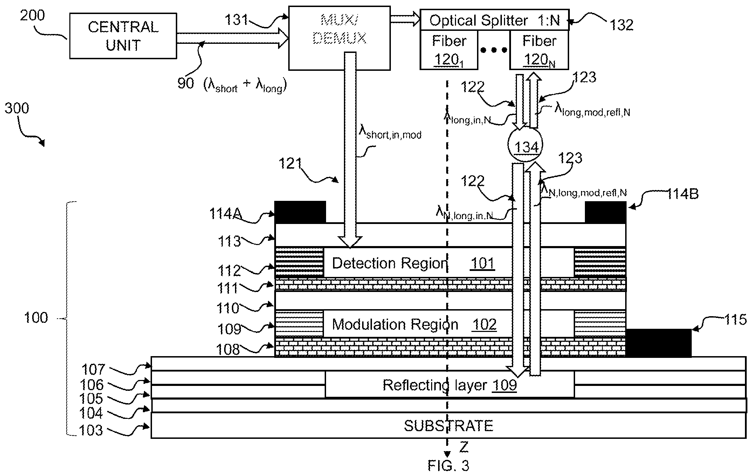

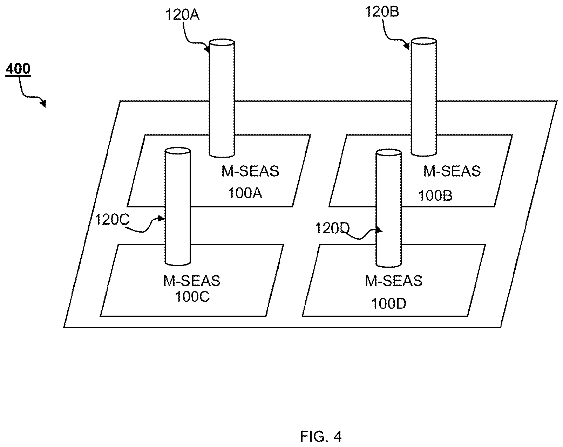

Additional reference is made to **FIGS. 3** and **4****.** According to some embodiments, an OTD **100** as schematically illustrated, for example, in **FIG.** 1 or **FIG. 2****,** may be integrally formed with additional optical (and optionally passive) components on the same substrate to form an integrated ROF communication system **300,** schematically shown in **FIG. 3** using, e.g., Si photonics fabrication technologies. In an embodiment, integrated optical system **300** may comprise an OTD **100,** a wavelength demultiplexer (Demux) **131,** an optical splitter **132** for splitting and coupling light into a plurality of waveguides **133,** and an optical circulator **134,** e.g., for each one of the plurality of waveguides.

In an embodiment, incoming modulated light **90** may have or encompass a plurality of short and long wavelengths. Incoming modulated light **90** may be launched into and split by Demux **131** into short and long wavelengths **λ_{short,mod,in}...λ_{long,in}.** Hence, modulated first wavelength light **121 (λₛₕₒᵣₜ,_{in,mod})** and unmodulated second wavelength light **122 λ_{long,in}** at comparably longer wavelengths is obtained.

Modulated light **121** at shorter wavelengths **λ_{short,mod,in}** of the downlink may be directed towards OTD **100** such to be incident onto detection region **101,** which may result in the voltage or current oscillations in detection region **101** that can be readout via first or second contacts **114A or 114B,** and third contact **115.**

Further, light **122** at the comparably longer wavelengths **λ_{long,in}** may be split by optical splitter **132** into a plurality of light waves **λ_{long,in,1}...λ_{long,N}** of the same wavelength which are then coupled into a respective plurality of waveguides or fibers **120₁,...120_{N}.** Light **121** at each one of the longer wavelengths **λ_{long,in,1-N}** for being directed towards modulation region **102** of the same transceiver **100** via common optical circulator **134** to obtain modulated light waves to be launched back for the uplink. Reflected, modulated second, long wavelength light waves **123 λ_{long,refl,mod,1-N}** may be coupled back with the respective waveguides **120_{1-N}** via corresponding optical circulator **134** from the modulation regions **102** of the corresponding OTDs. Optical circulator **134** may be employed to allow in each OTD **100,** bidirectional propagation of first longer wavelengths **122 λ_{long,refl,mod,1-N}** and second longer wavelengths **123 λ_{long,refl,mod,1-N}** over the same optical waveguide (not shown). Otherwise stated, optical circulator **134,** which may be integrally formed with other components of OTD **100,** may be employed for separating incoming (downlink) short wavelength light **122** from the reflected long, modulated, wavelength light **123.**

With respect to the uplink, the above-described structure of integrated ROF communication system **300** enables concatenation of a plurality of OTDs **100** such that they may all share the same laser for generating respective modulated second wavelength light **123 λ_{long,refl,mod,1-N}** for corresponding uplinks. The plurality of modulated light waves carrying data and which are reflected from the different OTDs **100** can be collected by respective waveguides **120₁-120_{N}** and launched to the same photodetector at central unit **200.** **FIG. 4** shows schematically an array **400** of OTDs **100A-100D** that are communicably coupled with respective waveguides **120₁-120₄.** For example, each OTD **100** can be optically aligned with a separate optical fiber **120A-120D.** Alternatively, array **400** of OTDs **100A-100D** may be communicably coupled with the same fiber **120** using WDM, where each OTDs **100A-100D** may be designed to be responsive to a different wavelength or range of wavelengths.

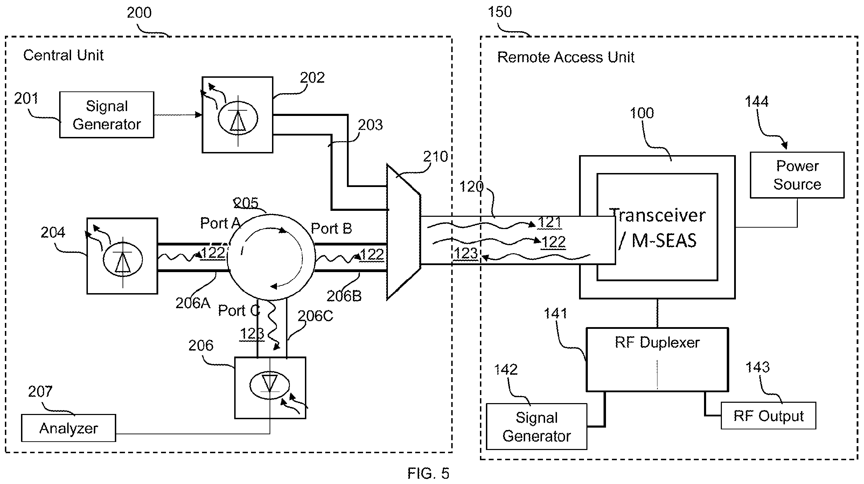

Referring now to **FIG. 5****,** a communication system **500** allowing full-duplex optical transmission may comprise central unit **200** that is communicatively coupled with a remote access unit **150.** According to an embodiment, central unit **200** may include a signal generator **201** and a "short" wavelength laser source **202** (e.g., 1310 nm). Signal generator **201** may modulate the light emitted by short wavelength laser source **202** to obtain first wavelength modulated light **121** at **λ_{short,in,mod},** which is coupled into a downlink fiber **203.** Central unit **200** may further include an optical duplexer **210** which is operative to couple first wavelength modulated light **121 (λ_{short,in,mod})** into shared fiber **120.** Shared or "duplex-carrying" fiber **120** carries first wavelength modulated light **121(λ_{short,in,mod})** from optical duplexer **210** to OTD **100** of remote access unit **150.** Remote access unit **150** may comprise a power source **144** for the operation of the OTD and, optionally, further electronic devices (not shown) such as, for example, amplifiers. At least some of first wavelength modulated light **121(λ_{short,in,mod})** may be incident onto the "upper" detection region or layer **101 (****Figs. 1-3****)** and, at least partially, absorbed thereby. Responsive to the absorption of light **121** by the detection region **101,** changes in the voltage difference or current between may be readout via third conductive contact **115** in cooperation with first or second contacts **114A** or **114B.** These changes in the voltage difference or current over time may be indicative of a signal envelope carried by first wavelength modulated light **121(λ_{short,in,mod}).** Data descriptive of these voltage changes may be transmitted using RF from or over a suitable RF output **133** of remote access unit **150** such as, for example, for example, an RF antenna, or a coaxial cable. RF output **133** may in some embodiments be operatively coupled to an RF duplexer **141** that provides RF from OTD **100** to RF output **143.**

According to an embodiment, with respect to RF-to-optical up-conversion for the transmission of data descriptive of information, ROF communication system **500** may comprise a "long" wavelength source **204** which is operatively coupled with a first uplink fiber portion **206A,** feeding the first uplink fiber portion **206A** with "long", unmodulated, second wavelength light **122,** passing through a first and second port **A** and **B** of circulator **205** into a second uplink fiber portion **206B.** Second uplink fiber portion **206B** is coupled to optical duplexer **210,** in parallel with downlink fiber **203.** Optical duplexer **210** may couple long, second, unmodulated wavelength light **122** into shared fiber **120.** Hence, short and long second wavelength light **121** and **122** may be concurrently transmitted over shared fiber **120.**

In some embodiments, unmodulated wavelength light **122** may be launched into a **1:N** splitter (cf. **FIG. 3****,** not shown in **FIG. 5**), in case a plurality of concatenated remote access units (not shown) comprising a respective plurality of OTDs **100** is employed.

Unmodulated wavelength light **122** may traverse without significant losses detection region **101 (****FIGs. 1-3****)** and impact modulation region **102,** where the long wavelength light **122** may be modulated by employing a signal generator **142** imposing corresponding changes in the properties of modulation region **102.** The light may be reflected back into shared fiber **120** as second, long wavelength, modulated light **123,** which is directed by circulator **205** from second uplink fiber portion **206B** into a third uplink fiber portion **206C.** Modulated light **123** is incident onto detector **206,** generating a corresponding uplink RF output. The uplink RF output may be analyzed using an analyzer **207.**

Modulation may be imposed onto at least some portion of long wavelength light **122,** e.g., through an electric analogue of digital modulation signal which invokes changes in the physical properties (e.g., light absorption properties) of modulation region **102.** These changes in the physical properties may, in turn, cause corresponding amplitude modulation of light in modulation region **102.** In other words, the intensity of at least some portion of the short wavelength light may be altered over time in dependence of the applied electrical signal to obtain second, long wavelength, modulated light **123.** The second, long wavelength, modulated light **123** may be coupled back into shared fiber **120** using a reflecting layer **109 (****Figs. 1-3****)** which may be for example be implemented as a distributed Bragg reflector. Second, long wavelength, modulated light **123** may propagate back via shared fiber **120** to central unit **200.** As already indicated with respect to **FIG. 2** with reference to the employment of OTD **100** that comprises a SESAM structure, a part of the incoming second, long wavelength signal **122** may be modulated and reflected as by the SESAM structure back into shared fiber **120** as second, long wavelength, modulated light signal **123,** while a rest portion may be coupled as second, modulated, long wavelength light **124** into waveguide layer **104** of the SESAM structure.

According to an embodiment, the electronic modulating signal comprises a biasing DC voltage component, e.g., in order to improve the modulation efficiency and responsivity of modulation region **102.**

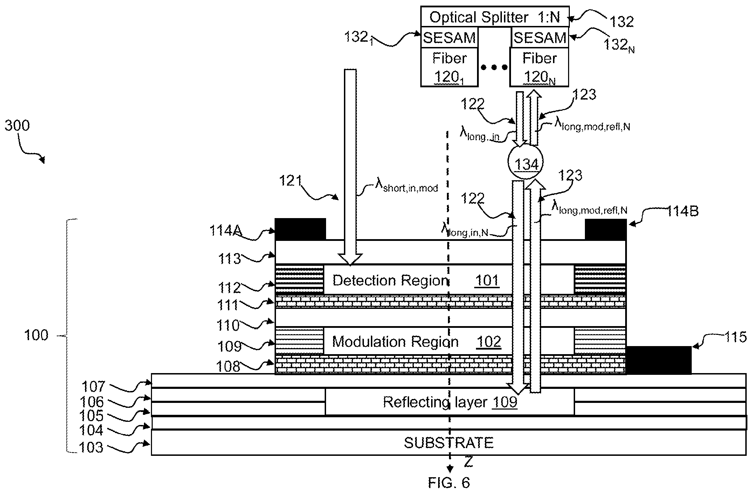

Referring now to **FIG. 6****,** SESAM structures **133₁-133_{N}** may be employed between respective outputs of splitter **132** and inputs of fibers **120₁-120_{N}.** SESAM structures **133₁-133_{N}** may be employed for controlling the transparency and, hence, the power distribution between different OTDs **100** according to ROF communication system requirements. The power distribution may be for example be tuned or controlled according to the architecture and/or topology of full-duplex ROF communication system **500.** The power distribution may for instance be adapted in accordance with the distance between central unit **200** and remote access unit **150** and/or the number of concatenated OTDs **100.**

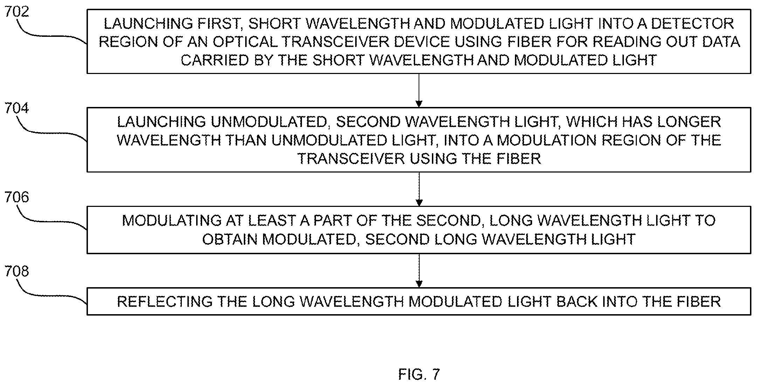

Further reference is made to **FIG. 7****.** An embodiment of a method for enabling full-duplex data transmission may include as indicated by block **702,** for example, launching first, short wavelength and modulated light **121** into detection region **101** of OTD, e.g., using fiber **120,** for reading out data carried by the short wavelength and modulated light **121.**

As indicated by block **704,** the method may further include, for example, launching unmodulated, second long wavelength light **122,** which has a longer wavelength than first, short wavelength and modulated light **121,** into modulation region **102** of OTD **100,** e.g., using fiber **120.** Modulation region **102** is located downstream of detection region **101** with respect to the direction of propagation of both the short and long wavelength light **121** and **122.** Detection region **101** is substantially transparent to second wavelength light **122.** In other words, attenuation of second wavelength light passing or propagating through detection region **101** may be negligible.

As indicated by box **706,** the method may further include, for example, modulating at least a part of the second, long wavelength light **122** to obtain second, long wavelength modulated light **123.**

As indicated by box **708,** the method may include, reflecting at least a portion of the second, long wavelength modulated light **123,** back into the fiber **120.**

In the claims or specification of the present application, unless otherwise stated, adjectives such as "substantially" and "about" modifying a condition or relationship characteristic of a feature or features of an embodiment of the invention, are understood to mean that the condition or characteristic is defined to within tolerances that are acceptable for operation of the embodiment for an application for which it is intended.

It should be understood that where the claims or specification refer to "a" or "an" element, such reference is not to be construed as there being only one of that element.

In the description and claims of the present application, each of the verbs, "comprise" "include" and "have", and conjugates thereof, are used to indicate that the object or objects of the verb are not necessarily a complete listing of components, elements or parts of the subject or subjects of the verb.

While this disclosure describes a limited number of embodiments, it will be appreciated that many variations, modifications and other applications of such embodiments may be made. The disclosure is to be understood as not limited by the specific embodiments described herein, but only by the scope of the appended claims.

## Claims

1. An optical transceiver device (OTD) (100), comprising:
a detection region (101) for detecting light at a first wavelength for down-conversion of the detected light into wireless signals;
**characterized in that** the OTD (100) further comprises:
an electro-absorption modulation region (102) for modulating light having a second wavelength longer than the first wavelength by changing the forbidden gap of the modulation region (102) according to input analog and/or digital signals to invoke changes in light absorption properties of the electro-absorption modulation region (102);
wherein the detection region (101) is substantially transparent to light at the second wavelength and located upstream to the modulation region (102) with respect to direction of propagation of first wavelength light incident onto the detection region (101).

2. The OTD (100) according to claim 1, wherein the detection region (101) comprises a plurality of quantum wells.

3. The OTD (100) according to any of the preceding claims, further comprising a reflecting layer (109) for reflecting the second wavelength light for up-conversion.

4. The OTD (100) according to claim 3, wherein the reflecting layer (109) comprises a Distributed Bragg Reflective mirror having a plurality of periodic variations of a characteristic parameter.

5. The OTD (100) according to claim 3, wherein the reflecting layer (109) is partially transparent and overlays a waveguide layer (104) so that a portion of incident second wavelength light is reflected and another portion of the incident second wavelength light is coupled into the waveguide layer (104).

6. The OTD (100) of claim 5, wherein the reflecting layer (109) comprises a semiconductor saturable absorber mirror.

7. The OTD (100) according to any one of claims 1 to 2 or 4 to 6, comprising a plurality of readout contacts (114A-B, 115) for reading out a voltage fluctuation and/or an electric current generated due to first wavelength light incident onto the detection region (101).

8. An array (400) comprising a plurality of OTDs (100A-D) according to any one of claims 1 to 2 or 4 to 6.

9. The array (400) according to claim 8, wherein each OTD (100) is optically coupled with an optical fiber for allowing full-duplex data transmission over each fiber.

10. A communication system (300, 500), comprising:
an OTD (100) according to any of the claims 1 to 2 or 4 to 6, wherein an electrical and/or optical component can be integrally formed with the OTD (100).

11. The communication system (300, 500) of claim 10, wherein the electrical and/or optical component is an amplifier.

12. The communication system (300, 500) according to claim 10 or 11, further comprising a wavelength division demultiplexer (131) for separating first wavelength light from second wavelength light, wherein the OTD (100) and the demultiplexer (131) are formed integrally with each other.

13. The communication system (300, 500) according to claim 12, further comprising a splitter (132) for splitting the second wavelength light into a plurality of second wavelength light portions, wherein the splitter is formed integrally with the transceiver device and the demultiplexer (131).

14. The communication system (300, 500) according to claim 13, further comprising an optical circulator (134), which is formed integrally with the OTD (100) to allow full-duplex transmission of data carried by the modulated first wavelength light and the modulated and reflected second wavelength light.

15. A method for enabling full-duplex data transmission comprising:
launching modulated light at a first short wavelength from an optical fiber into a detection region (101) of an OTD (100) according to any of claims 1 to 2 or 4 to 6 for reading out data carried by the modulated short wavelength light;
launching unmodulated light at a second wavelength which is longer than the first wavelength from the optical fiber into an electro-absorption modulation region (102) of the OTD (100);
modulating at least a part of the second, longer wavelength light by changing the forbidden gap of the modulation region (102) according to input analog and/or digital signals to obtain modulated, second long wavelength light; and
reflecting the second long wavelength modulated light into the optical fiber.

## Patentansprüche

1. Optische Sender-Empfänger-Vorrichtung (OTD) (100), umfassend:
einen Detektionsbereich (101) zum Detektieren von Licht mit einer ersten Wellenlänge zur Abwärtswandlung des detektierten Lichts in drahtlosen Signalen;
**dadurch gekennzeichnet, dass** die OTD (100) ferner Folgendes umfasst:
einen Elektroabsorptionsmodulationsbereich (102) zum Modulieren von Licht mit einer zweiten Wellenlänge, welche länger als die erste Wellenlänge ist, durch Verändern des verbotenen Bands des Modulationsbereichs (102) gemäß analoger und/oder digitaler Eingangssignale, um Änderungen der Lichtabsorptionseigenschaften des Elektroabsorptionsmodulationsbereichs (102) aufzurufen;
wobei der Detektionsbereich (101) im Wesentlichen bei der zweiten Wellenlänge lichttransparent und stromaufwärts des Modulationsbereichs (102) im Verhältnis zu der Ausbreitungsrichtung des Lichts mit der ersten Wellenlänge angeordnet ist, welches auf den Detektionsbereich (101) einfällt.

2. OTD (100) nach Anspruch 1, wobei der Detektionsbereich (101) eine Mehrzahl von Quantentrögen umfasst.

3. OTD (100) nach einem der vorhergehenden Ansprüche, ferner umfassend eine reflektierende Schicht (109) zum Reflektieren, zur Aufwärtswandlung, des Lichts mit der zweiten Wellenlänge.

4. OTD (100) nach Anspruch 3, wobei die reflektierende Schicht (109) einen verteilten Bragg-Reflexionsspiegel umfasst, welcher eine Mehrzahl von periodischen Variationen eines charakteristischen Parameters aufweist.

5. OTD (100) nach Anspruch 3, wobei die reflektierende Schicht (109) teilweise transparent ist und eine Wellenleiterschicht (104) überlagert, sodass ein Teil des einfallenden Lichts mit der zweiten Wellenlänge reflektiert wird und ein anderer Teil des einfallenden Lichts mit der zweiten Wellenlänge in die Wellenleiterschicht (104) gekoppelt wird.

6. OTD (100) nach Anspruch 5, wobei die reflektierende Schicht (109) einen sättigbaren Halbleiter-Absorberspiegel umfasst.

7. OTD (100) nach einem der Ansprüche 1 bis 2 oder 4 bis 6, umfassend eine Mehrzahl von Lesekontakten (114A-B, 115) zum Auslesen einer Spannungsschwankung und/oder eines elektrischen Stroms, welcher von dem Licht mit der ersten Wellenlänge erzeugt wird, welcher auf den Detektionsbereich (101) einfällt.

8. Array (400), umfassend eine Mehrzahl von OTDs (100A-D) nach einem der Ansprüche 2 oder 4 bis 6.

9. Array (400) nach Anspruch 8, wobei jede OTD (100) optisch mit einer optischen Faser gekoppelt ist, um eine Vollduplex-Datenübertragung über jede Faser zu ermöglichen.

10. Kommunikationssystem (300, 500), umfassend:
eine OTD (100) nach einem der Ansprüche 1 bis 2 oder 4 bis 6, wobei eine elektrische und/oder optische Komponente mit der OTD (100) einstückig geformt ist.

11. Kommunikationssystem (300, 500) nach Anspruch 10, wobei die elektrische und/oder optische Komponente ein Verstärker ist.

12. Kommunikationssystem (300, 500) nach Anspruch 10 oder 11, ferner umfassend einen Wellenlängendivisions-Demultiplexer (131) zum Trennen des Lichts mit der ersten Wellenlänge von dem Licht mit der zweiten Wellenlänge, wobei die OTD (100) und der Demultiplexer (131) einstückig miteinander geformt sind.

13. Kommunikationssystem (300, 500) nach Anspruch 12, ferner umfassend einen Splitter (132) zum Teilen des Lichts mit der zweiten Wellenlänge in eine Mehrzahl von Lichtteilen mit der zweiten Wellenlänge, wobei der Splitter einstückig mit der Sender-Empfänger-Vorrichtung und dem Demultiplexer (131) geformt ist.

14. Kommunikationssystem (300, 500) nach Anspruch 13, ferner umfassend einen optischen Zirkulator (134), welcher einstückig mit der OTD (100) geformt ist, um eine Vollduplex-Übertragung von Daten zu ermöglichen, welche durch das modulierte Licht mit der ersten Wellenlänge und durch das modulierte reflektierte Licht mit der zweiten Wellenlänge transportiert werden.

15. Verfahren zum Ermöglichen einer Vollduplex-Datenübertragung, umfassend:
Einkoppeln von moduliertem Licht mit einer ersten kurzen Wellenlänge von einer optischen Faser in einen Detektionsbereich (101) einer OTD (100) nach einem der Ansprüche 1 bis 2 oder 4 bis 6 zum Auslesen von Daten, welche durch das modulierte Licht mit der kurzen Wellenlänge transportiert werden;
Einkoppeln von unmoduliertem Licht mit einer zweiten Wellenlänge, welche länger als die erste Wellenlänge ist, von der optischen Faser in einen ElektroabsorptionsModulationsbereich (102) der OTD (100);
Modulieren mindestens eines Teils des Lichts mit der zweiten längeren Wellenlänge durch Verändern des verbotenen Bands des modulierten Bereichs (102) gemäß analoger und/oder digitaler Eingangssignale, um moduliertes Licht mit einer zweiten langen Wellenlänge zu erhalten; und
Reflektieren des modulierten Lichts mit der zweiten langen Wellenlänge in die optische Faser.

## Revendications

1. Dispositif émetteur-récepteur optique (OTD) (100), comprenant :
une région de détection (101) permettant de détecter de la lumière à une première longueur d'onde pour une conversion descendante de la lumière détectée dans des signaux sans fil ;
**caractérisé en ce que** l'OTD (100) comprend en outre :
une région de modulation d'électro-absorption (102) permettant de moduler la lumière présentant une seconde longueur d'onde plus longue que la première longueur d'onde en modifiant l'intervalle interdit de la région de modulation (102) selon des signaux d'entrée analogiques et/ou numériques pour invoquer des changements de propriétés d'absorption de la lumière de la région de modulation d'électro-absorption (102) ;
dans lequel la région de détection (101) est sensiblement transparente à la lumière à la seconde longueur d'onde et située en amont de la région de modulation (102) relativement à la direction de propagation de la lumière de première longueur d'onde, qui est incidente sur la région de détection (101).

2. OTD (100) selon la revendication 1, dans lequel la région de détection (101) comprend une pluralité de puits quantiques.

3. OTD (100) selon l'une quelconque des revendications précédentes, comprenant en outre une couche réfléchissante (109) permettant de réfléchir la lumière de seconde longueur d'onde pour une conversion ascendante.

4. OTD (100) selon la revendication 3, dans lequel la couche réfléchissante (109) comprend un miroir réfléchissant de Bragg distribué présentant une pluralité de variations périodiques d'un paramètre caractéristique.

5. OTD (100) selon la revendication 3, dans lequel la couche réfléchissante (109) est partiellement transparente et recouvre une couche de guide d'onde (104) de sorte qu'une partie de la lumière incidente de seconde longueur d'onde est réfléchie et une autre partie de la lumière incidente de seconde longueur d'onde est couplée dans la couche de guide d'onde (104).

6. OTD (100) selon la revendication 5, dans lequel la couche réfléchissante (109) comprend un miroir absorbeur saturable à semi-conducteur.

7. OTD (100) selon l'une quelconque des revendications 1 à 2 ou 4 à 6, comprenant une pluralité de contacts de lecture (114A à B, 115) permettant de relever une fluctuation de tension et/ou un courant électrique généré du fait de la lumière de première longueur d'onde, qui est incidente sur la région de détection (101).

8. Réseau (400) comprenant une pluralité d'OTD (100A à D) selon l'une quelconque des revendications 1 à 2 ou 4 à 6.

9. Réseau (400) selon la revendication 8, dans lequel chaque OTD (100) est couplé de manière optique à une fibre optique pour permettre une transmission de données en duplex intégral sur chaque fibre.

10. Système de communication (300, 500), comprenant :
un OTD (100) selon l'une quelconque des revendications 1 à 2 ou 4 à 6, dans lequel un composant électrique et/ou optique peut être formé d'un seul tenant avec l'OTD (100).

11. Système de communication (300, 500) selon la revendication 10, dans lequel le composant électrique et/ou optique est un amplificateur.

12. Système de communication (300, 500) selon la revendication 10 ou 11, comprenant en outre un démultiplexeur à division de longueur d'onde (131) permettant de séparer une lumière de première longueur d'onde d'une lumière de seconde longueur d'onde, dans lequel l'OTD (100) et le démultiplexeur (131) sont formés d'un seul tenant l'un avec l'autre.

13. Système de communication (300, 500) selon la revendication 12, comprenant en outre un diviseur (132) permettant de diviser la lumière de seconde longueur d'onde en une pluralité de parties de lumière de seconde longueur d'onde, dans lequel le diviseur est formé d'un seul tenant avec le dispositif émetteur-récepteur et le démultiplexeur (131).

14. Système de communication (300, 500) selon la revendication 13, comprenant en outre un circulateur optique (134), qui est formé d'un seul tenant avec l'OTD (100) pour permettre une transmission en duplex intégral de données transportées par la lumière modulée de première longueur d'onde et la lumière modulée et réfléchie de seconde longueur d'onde.

15. Procédé permettant une transmission de données en duplex intégral comprenant :
le lancement d'une lumière modulée à une première longueur d'onde courte d'une fibre optique dans une région de détection (101) d'un OTD (100) selon l'une quelconque des revendications 1 à 2 ou 4 à 6, permettant de relever des données transportées par la lumière modulée à longueur d'onde courte;
le lancement d'une lumière non-modulée à une seconde longueur d'onde, qui est plus longue que la première longueur d'onde, depuis la fibre optique dans une région de modulation d'électro-absorption (102) de l'OTD (100) ;
la modulation au moins d'une partie de la lumière de seconde longueur d'onde plus longue en modifiant l'intervalle interdit de la région de modulation (102) selon des signaux d'entrée analogiques et/ou numériques pour obtenir une lumière modulée de seconde longueur d'onde longue ; et
la réflexion de la lumière modulée de seconde longueur d'onde longue dans la fibre optique.
